(19) Europäisches Patentamt
European Patent Office
Office européen des brevets

(11) **EP 3 274 678 B1**

(12) **FASCICULE DE BREVET EUROPEEN**

(45) Date de publication et mention
de la délivrance du brevet:
**27.10.2021 Bulletin 2021/43**

(21) Numéro de dépôt: **16711211.9**

(22) Date de dépôt: **16.03.2016**

(51) Int Cl.:
$G01J\ 9/04^{(2006.01)}$      $G01S\ 17/00^{(2020.01)}$
$H01S\ 5/0683^{(2006.01)}$

(86) Numéro de dépôt international:
**PCT/EP2016/055639**

(87) Numéro de publication internationale:
**WO 2016/150783 (29.09.2016 Gazette 2016/39)**

(54) **PROCEDE DE MESURE DE LA MODULATION DE FREQUENCE D'UNE SOURCE LASER**

VERFAHREN ZUR MESSUNG DER FREQUENZMODULATION EINER LASERQUELLE

METHOD FOR MEASURING THE FREQUENCY MODULATION OF A LASER SOURCE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.03.2015 FR 1500603**

(43) Date de publication de la demande:
**31.01.2018 Bulletin 2018/05**

(73) Titulaire: **Thales**
**92400 Courbevoie (FR)**

(72) Inventeurs:
• **MINET, Jean**
**91767 Palaiseau (FR)**
• **PILLET, Grégoire**
**91767 Palaiseau (FR)**
• **FENEYROU, Patrick**
**91767 Palaiseau (FR)**

(74) Mandataire: **Marks & Clerk France**
**Immeuble "Visium"**
**22, avenue Aristide Briand**
**94117 Arcueil Cedex (FR)**

(56) Documents cités:
**US-A- 5 808 743**

• **Bartosz K Nowakowski ET AL: "DEVELOPMENT OF A MINIATURE, MULTICHANNEL, EXTENDED-RANGE FABRY-PEROT FIBER-OPTIC LASER INTERFEROMETER SYSTEM FOR LOW FREQUENCY SI-TRACEABLE DISPLACEMENT MEASUREMENT", , 1 novembre 2014 (2014-11-01), XP055246904, DOI: 10.13140/2.1.1284.5764 Extrait de l'Internet: URL:https://www.researchgate.net/profile/Bartosz_Nowakowski/publication/268686148_DEVELOPMENT_OF_A_MINIATURE_MULTICHANNEL_EXTENDED-_RANGE_FABRY-PEROT_FIBER-OPTIC_LASER_INTERFEROMETER_SYSTEM_FOR_LOW_FREQUENCY_SI-TRACEABLE_DISPLACEMENT_MEASUREMENT/links/547360800cf24bc8ea1b0ba2.pdf?inViewer=0&pd fJsDownloa [extrait le 2016-02-02]**
• **THOMAS S. SCHWARZE ET AL: "Advanced phasemeter for deep phase modulation interferometry", OPTICS EXPRESS, vol. 22, no. 15, 21 juillet 2014 (2014-07-21), page 18214, XP055246228, ISSN: 2161-2072, DOI: 10.1364/OE.22.018214**

**EP 3 274 678 B1**

**Description**

Le domaine de l'invention est celui de la mesure et éventuellement du contrôle de la modulation de fréquence d'une source laser.

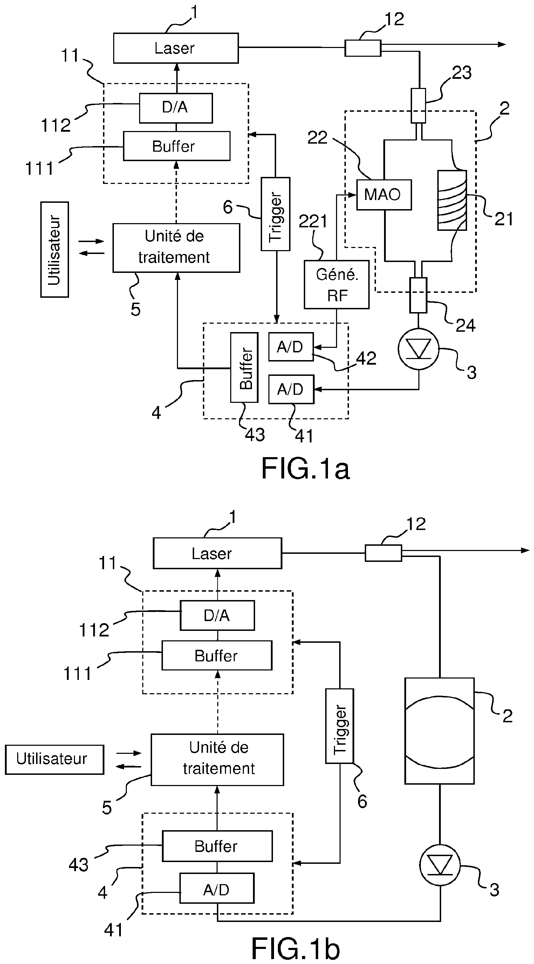

Jusqu'à présent, la mesure de la modulation de fréquence d'une source laser était le plus souvent obtenue à l'aide d'un interféromètre de type Mach-Zehnder ou de type Michelson dont l'un des deux bras comportait un modulateur acousto-optique. Un exemple d'un système de ce type est montré figure 1a. Il comprend :

- une source laser 1, avec une commande 11 de tension de modulation correspondant à une consigne de fréquence $f_0(t)$, munie d'une unité 111 de stockage de consignes numériques et d'un convertisseur 112 de ces consignes numériques en signaux analogiques $f_0(t)$,
- un coupleur 12 prélevant une partie de la lumière émise pour l'envoyer vers un interféromètre 2,
- un interféromètre à deux bras de type Mach-Zehnder 2 avec sur un bras une ligne à retard 21 et sur l'autre un modulateur acousto-optique (ou « MAO ») 22 lui-même associé à un générateur RF 221, et deux coupleurs permettant l'un 23 de séparer de préférence en deux parties égales et l'autre 24 de recombiner la lumière passant dans les deux bras,
- une photodiode 3 apte à convertir le signal d'intensité lumineuse de battement issu de l'interféromètre, en un signal électrique analogique,
- un dispositif 4 de mesure des signaux fournis par la photodiode 3 qui comporte un convertisseur 41 de ces signaux analogiques en signaux numériques, un convertisseur 42 des signaux analogiques du générateur en signaux numériques et réciproquement relié au générateur 221, et une unité de stockage 43 à des instants prédéterminés des signaux numériques issus des convertisseurs 41 et 42,
- une unité de traitement 5 des signaux stockés, et de transmission d'une tension déterminée à la commande 11,
- un dispositif de synchronisation 6 entre l'unité de stockage 43, le modulateur acousto-optique 22 (via le convertisseur 42 et le générateur 221) et la commande de tension 11.

La fréquence est déterminée à partir de l'analyse du signal obtenu en sortie de l'interféromètre ; il s'agit d'un signal de battement entre les deux signaux émergeant respectivement des deux bras.

Le signal mesuré par la photodiode (hors composante continue) est alors :

$$x(t) \propto \cos(\varphi(t) - \varphi(t - \tau) + 2\pi f_{mao} t)$$

où $\varphi(t)$ est la phase de la source laser, où $f_{mao}$ est la fréquence du modulateur acousto-optique et $\tau$ est le délai (ou retard) induit par la fibre optique et correspondant à la différence de trajet entre les deux bras de l'interféromètre de Mach-Zehnder 2. La différence de phase $\varphi(t) - \varphi(t-\tau)$ est caractéristique de la fréquence $f(t)$ du laser selon la relation suivante :

$$\varphi(t) - \varphi(t - \tau) = 2\pi \int_{t-\tau}^{t} f(t)dt \simeq 2\pi\tau f(t) \qquad (1)$$

Pour évaluer la fréquence du laser, il convient donc de calculer :

$$x(t) \cdot \exp(-2i\pi f_{mao} t)$$

puis d'appliquer un filtre passe-bas de fréquence de coupure inférieure à $f_{mao}$. On trouve alors z(t) tel que :

$$z(t) \propto \exp\big(i\varphi(t) - i\varphi(t - \tau)\big)$$

L'évaluation de l'argument complexe de $z$(t) permet enfin de déduire la fréquence du laser selon l'équation (1).

Cette méthode repose sur la translation de fréquence induite par le modulateur acousto-optique.

Les modulateurs acousto-optiques sont des composants susceptibles de pénaliser directement la taille, la masse, la consommation électrique, la fiabilité, et le coût des systèmes dans lesquels ils sont utilisés. Ces pénalités peuvent aussi être indirectes. Par exemple, il peut être nécessaire de réaliser un blindage électromagnétique de la chaîne de détection en raison des interférences causées par le modulateur acousto-optique. De plus, on peut aussi remarquer que le travail à des fréquences intermédiaires élevées nécessite la mise en œuvre d'une chaîne de détection plus complexe.

D'autres solutions permettent de mesurer la modulation de fréquence de la source laser. La solution la plus simple est basée sur l'utilisation d'un interféromètre « peu ambigu » au voisinage de la quadrature de phase, comme par exemple un interféromètre de type Mach-Zehnder comportant un délai très court ou un résonateur optique à grand intervalle spectral libre. Un exemple d'un système de ce type équipé d'un résonateur de type Fabry-Perot est montré figure 1b. Il comprend :

- une source laser 1, avec une commande 11 de tension de modulation correspondant à une consigne de fréquence $f_0(t)$, munie d'une unité 111 de stockage de consignes numériques et d'un convertisseur 112 de ces consignes numériques en signaux analogiques $f_0(t)$,
- un coupleur 12 prélevant une partie de la lumière émise pour l'envoyer vers un interféromètre 2,
- un résonateur de type Fabry-Perot 2,
- une photodiode 3 apte à convertir le signal d'intensité lumineuse issu du résonateur 2, en un signal électrique analogique,
- un dispositif 4 de mesure des signaux fournis par la photodiode 3 qui comporte un convertisseur 41 de ces signaux analogiques en signaux numériques, et une unité de stockage 43 à des instants prédéterminés des signaux numériques issus du convertisseur 41,
- une unité de traitement 5 des signaux stockés, et de transmission d'une tension déterminée à la commande 11,
- un dispositif de synchronisation 6 entre l'unité de stockage 43 et la commande de tension 11.

Dans ce cas, le signal mesuré par la photodiode en sortie de l'interféromètre ou du résonateur s'écrit :

$$x(t) = A \cdot F\big(f(t)\big)$$

avec A un facteur de proportionnalité dépendant de la puissance injectée et F une fonction monotone (et donc inversible) sur la plage d'excursion possible de la fréquence $f(t) = f_{moy} + \Delta f(t)$ du laser. Par exemple, dans le cas de l'interféromètre à délai court, si les puissances sont parfaitement équilibrées, nous avons :

$$x(t) \propto \cos\big(\varphi(t) - \varphi(t - \tau)\big) + 1 \simeq \cos\big(2\pi\tau f(t)\big) + 1$$

Une condition nécessaire pour que la fonction soit inversible est que $\tau$ soit suffisamment petit pour que $|2\pi \Delta f(t)\tau| < \pi$.

Ainsi, cette technique n'est malheureusement pas adaptée aux applications pour lesquelles une grande dynamique de modulation et une grande précision de mesure sont requises simultanément. De plus, la dépendance du facteur de proportionnalité A à la puissance peut dégrader la précision de mesure de la fréquence. Enfin, la dérive du système peut engendrer une dérive de la mesure (par exemple la perte de l'équilibre de puissance entre les deux voies de l'interféromètre ou le décalage spectral de la réponse du résonateur).

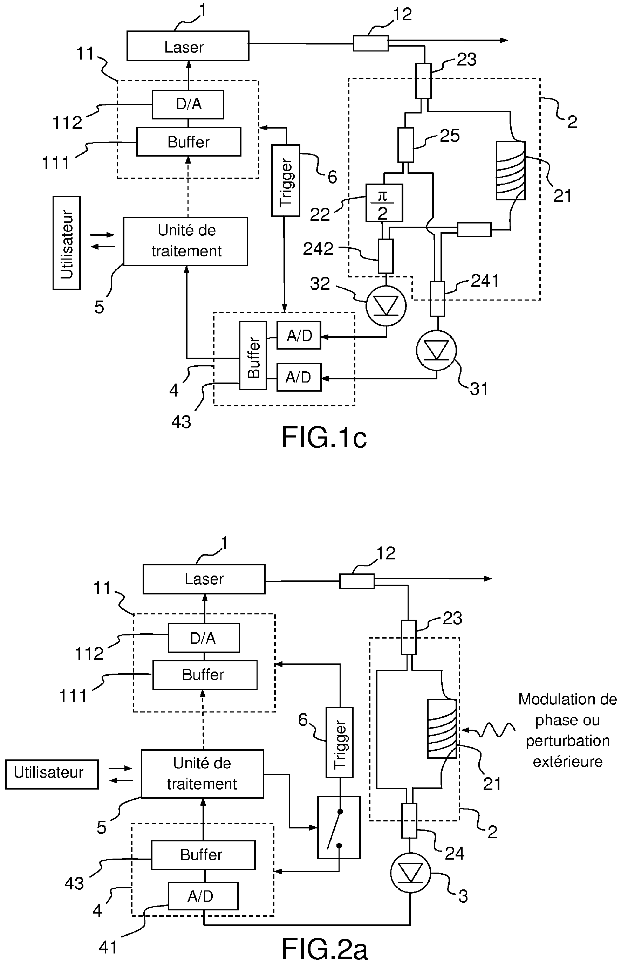

Une dernière solution consiste à mesurer simultanément la composante en phase et la composante en quadrature du signal interférométrique issues d'un double interféromètre à deux bras. Un exemple d'un système de ce type avec un interféromètre de type Mach Zehnder est montré figure 1c. Il comprend :

- une source laser 1, avec une commande 11 de tension de modulation correspondant à une consigne de fréquence $f_0(t)$, munie d'une unité 111 de stockage de consignes numériques et d'un convertisseur 112 de ces consignes numériques en signaux analogiques $f_0(t)$,
- un coupleur 12 prélevant une partie de la lumière émise pour l'envoyer vers un interféromètre 2,
- un interféromètre à deux bras de type Mach-Zehnder 2 avec un coupleur 23 pour séparer de préférence en deux parties égales la lumière reçue du coupleur 12, et sur un bras une ligne à retard 21 ; le signal lumineux sur l'autre bras est séparé par un coupleur 25 en :

  ○ une composante en phase qui est ensuite recombinée par un coupleur 241 avec la lumière passant par l'autre bras et,
  ○ une composante en quadrature obtenue par un élément 22 tel qu'une lame quart d'onde, qui est ensuite recombinée par un coupleur 242 avec la lumière passant par l'autre bras ,

- une première photodiode 31 apte à convertir en un premier signal électrique analogique, le signal d'intensité lumineuse de battement entre le signal retardé et la composante en phase, issus de l'interféromètre,
- une seconde photodiode 32 apte à convertir en un second signal électrique analogique, le signal d'intensité lumineuse de battement entre le signal retardé et la composante en quadrature, issus de l'interféromètre,
- un dispositif 4 de mesure des signaux fournis par les photodiodes 31, 32 qui comporte un convertisseur 41 relié à la première diode 31, un convertisseur 42 relié à la seconde diode 32, et une unité de stockage 43 à des instants prédéterminés des signaux numériques issus des convertisseurs 41 et 42,
- une unité de traitement 5 des signaux stockés, et de transmission d'une tension déterminée à la commande 11,
- un dispositif de synchronisation 6 entre l'unité de stockage 43, et la commande de tension 11.

Dans ce cas, on mesure x(t) = A · cos($\varphi$(t) - $\varphi$(t - $\tau$)) + B et y(t) = C · sin($\varphi$(t) - $\varphi$(t-$\tau$)) + D où A, B, C, D sont des facteurs dépendant de la puissance injectée et de l'équilibre des puissances entre les voies des interféromètres. La connaissance parfaite de ces facteurs permet de mesurer :

$$z = \frac{x(t) - B}{A} + i \frac{y(t) - D}{C} = \exp\big(i\varphi(t) - i\varphi(t - \tau)\big)$$

Cette technique est intéressante car elle permet d'obtenir un bon compromis précision / dynamique par l'utilisation d'interféromètres de grande finesse (i.e. comportant un délai long). Cette technique permet de se passer de modulateur acousto-optique. Néanmoins, elle requiert une lame quart d'onde fixe dans le temps. De plus, elle nécessite un contrôle très précis de la phase, l'acquisition de deux signaux simultanément et la bonne connaissance des facteurs A, B, C, D qui dépendent de la puissance incidente, de l'équilibre des puissances des voies, et qui sont ainsi susceptibles de dériver dans le temps.

D'autres exemples de l'état de la technique sont décrits dans US5808743 et dans l'article "Development of a miniature, multichannel, extended-range Fabry-Perot fiber-optic laser interferometer system for low frequency SI-traceable displacement measurement" de B. Nowakowski et al., 2014.

Le but de l'invention est de pallier ces inconvénients. En conséquence, il demeure à ce jour un besoin pour un procédé de mesure de la modulation de fréquence d'une source laser, donnant simultanément satisfaction à l'ensemble des exigences précitées, en termes de bon compromis précision / dynamique, et de coût, d'encombrement et de fiabilité du système utilisé pour mettre en œuvre le procédé.

Selon l'invention, la mesure de la modulation de fréquence d'une source laser est aussi obtenue à l'aide d'un interféromètre à deux bras (de type Mach-Zehnder ou Michelson par exemple) dont l'un des deux bras est décalé d'un délai, mais dans les conditions d'utilisation suivantes :

- le signal de modulation est périodique et
- les mesures de battement sont acquises sur différentes périodes de modulation dans des conditions d'interférences distinctes basées sur une différence de phase entre les bras de l'interféromètre qui varie peu à l'échelle d'une période de modulation de fréquence (typiquement quelques centaines de $\mu$s) mais considérablement à l'échelle de la période de répétition de la mesure (quelques s). Cela permet de construire virtuellement la composante en phase et la composante en quadrature du signal interférométrique. On en déduit alors la modulation de fréquence du laser.

Plus précisément l'invention a pour objet un procédé de mesure de la modulation de fréquence f(t) d'une source laser tel que défini dans la revendication 1.

Ce procédé permet de mesurer avec un bon compromis précision / dynamique, la fréquence de modulation d'une source laser à l'aide d'un simple interféromètre à deux bras qui ne comporte pas de modulateur acousto-optique. Cela permet de s'affranchir des inconvénients liés à l'utilisation de ce composant (coût, encombrement, fiabilité, ...). En outre, la solution proposée repose sur une analyse d'un signal qui peut être à basse fréquence ce qui permet alors de relâcher certaines contraintes sur la chaîne de détection et de traitement du signal, telles que les contraintes sur l'échantillonneur.

Le calcul comporte :

- une organisation des mesures réitérées homologues d'une période à l'autre sous forme de vecteurs x(t), $0 \leq t \leq T$, et
- ces vecteurs x(t) décrivant un cylindre elliptique, un calcul de l'axe $w_0$ du cylindre,
- une projection selon l'axe $w_0$ sur un plan déterminé, cette projection étant paramétrée par un angle fonction de f(t). En pratique, cette fonction est avantageusement développée au premier ordre et la projection est alors paramétrée par un angle proportionnel à f(t).

La période T est typiquement de l'ordre de quelques $\mu$s (de 5 $\mu$s à 1 ms), et le retard $\tau$ évolue typiquement sur

une durée variant de cent millisecondes à une minute (de 100 ms à 1 mn).

Selon une variante de l'invention, la variation temporelle du retard $\tau$ est stimulée au moyen d'un dispositif piézo-électrique.

L'invention peut être utilisée pour calibrer le signal de commande afin d'approcher au mieux une modulation de fréquence prédéfinie par l'utilisateur. A cet effet, l'invention concerne également un procédé de calibrage de la fréquence de la source laser d'un lidar selon une consigne $f_0(t)$, qui comprend les étapes suivantes :

- modulation de la fréquence de la source laser au moyen d'une tension de commande périodique U(t) prédéterminée,
- définition d'une transformation linéaire entre f(t) et U(t), qui peut être obtenue par exemple par la mesure de la fonction de transfert de la modulation de fréquence désignée FTM,
- calcul d'une première tension de commande $U_1(t)$ à partir de $f_0(t)$ et de ladite transformation linéaire,
- i=1 et itération des étapes suivantes :

  ○ mesure de la fréquence $f_i(t)$ de la source laser comme indiqué précédemment,
  ○ calcul de l'erreur $\Delta f_i(t)=f_i(t) - f_0(t)$ et d'une tension de commande de correction à partir de $\Delta f_i(t)$ et de ladite transformation linéaire,
  ○ définition d'une nouvelle tension de commande $U_{i+1}(t)$ à partir de la tension de commande précédente $U_i(t)$ et de la tension de commande de correction,
  ○ i=i+1.

Le nombre d'itérations est généralement inférieur à 10.

L'invention a aussi pour objet un programme d'ordinateur, ledit programme d'ordinateur comprenant des instructions de code permettant d'effectuer les étapes du procédé tel que décrit, lorsque ledit programme est exécuté sur un ordinateur.

L'invention concerne également un système de mesure de la modulation de fréquence f(t) d'une source laser qui comprend :

- la source laser associée à une commande de modulation,
- un interféromètre à deux bras avec une ligne à retard sur l'un des bras,
- un dispositif de mesure de signaux de battement issus de l'interféromètre,
- une unité de traitement des signaux mesurés,
- un dispositif de synchronisation relié à la commande de modulation et à l'unité de traitement,

caractérisé en ce que l'unité de traitement est adaptée pour mettre en œuvre le procédé décrit.

L'interféromètre est par exemple de type Mach-Zehnder ou Michelson.

Avantageusement, l'interféromètre ne comporte pas de modulateur acousto-optique.

D'autres caractéristiques et avantages de l'invention apparaîtront à la lecture de la description détaillée qui suit, faite à titre d'exemple non limitatif et en référence aux dessins annexés dans lesquels :

les figures 1 représentent schématiquement des exemples de système de mesure de la modulation de fréquence d'une source laser selon l'état de la technique, avec un interféromètre à deux bras de type Mach Zehnder équipé d'un MAO (fig 1a), avec un résonateur optique (fig 1b), ou avec un interféromètre à deux bras apte à mesurer la composante en phase et la composante en quadrature du signal interférométrique (fig 1c),
les figures 2 représentent schématiquement un exemple de système de mesure de la modulation de fréquence d'une source laser apte à mettre en œuvre le procédé selon l'invention, utilisant un interféromètre de Mach-Zehnder (fig 2a) ou un interféromètre de Michelson (fig 2b),
les figures 3 représentent schématiquement un exemple de trajectoire du vecteur représentatif des mesures obtenues sur 2 périodes avec alors une trajectoire elliptique (fig 3a) et la transformation de cette trajectoire en un cercle de manière à obtenir directement la fréquence à une constante près (fig 3b),
la figure 4a représente schématiquement la projection dans un espace tri-dimensionnel composé des trois composantes principales d'un exemple de trajectoire du vecteur représentatif des mesures obtenues sur 400 périodes avec alors une trajectoire cylindrique à base elliptique, la figure 4b représente schématiquement la trajectoire de la figure 4a projetée sur un plan quasiment perpendiculaire à l'axe du cylindre et normalisée en un cercle, et la reconstruction de fréquence correspondante est montrée figure 4c,
la figure 5 illustre différentes étapes d'un procédé de calibrage de la fréquence d'une source laser selon l'invention,
la figure 6 représente schématiquement un exemple d'erreurs de modulation obtenues après i itérations.

D'une figure à l'autre, les mêmes éléments sont repérés par les mêmes références.

On décrit en relation avec la figure 2a un premier exemple de système de mesure apte à mettre en œuvre le procédé selon l'invention. Il comprend :

- une source laser 1, avec une commande 11 de tension de modulation correspondant à une consigne de fréquence $f_0(t)$, munie d'une unité 111 de stockage de consignes numériques et d'un convertisseur 112 de ces consignes numériques en signaux analogiques $f_0(t)$,
- un coupleur 12 prélevant une partie de la lumière émise pour l'envoyer vers un interféromètre 2,
- un interféromètre de type Mach-Zehnder 2 à deux bras, avec une ligne à retard 21 sur l'un de ses bras, et deux coupleurs permettant l'un 23 de séparer de préférence en deux parties égales et l'autre 24 de recombiner la lumière passant dans les deux bras,
- une photodiode 3 apte à convertir le signal d'intensité lumineuse issu de l'interféromètre 2, en un signal électrique analogique,
- un dispositif 4 de mesure des signaux fournis par la diode 3 qui comporte un convertisseur 41 de ces signaux analogiques en signaux numériques, et une unité de stockage 43 à des instants prédéterminés des signaux numériques issus du convertisseur 41,
- une unité de traitement 5 des signaux stockés, et de transmission d'une tension déterminée à la commande 11,
- un dispositif de synchronisation 6 entre l'unité de stockage 43 et la commande de tension 11, également reliée à l'unité de traitement.

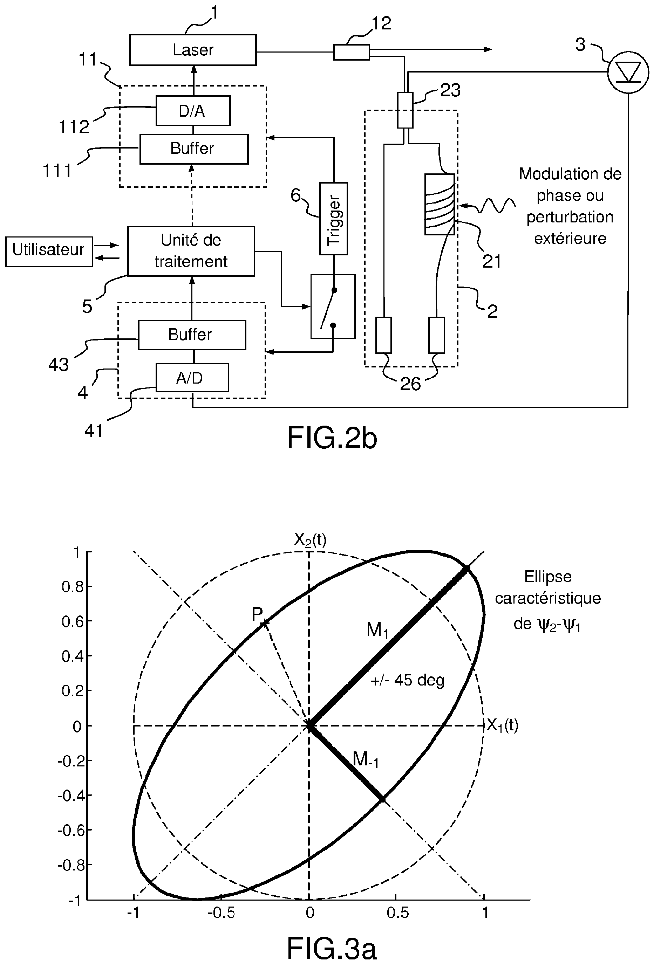

On décrit en relation avec la figure 2b un autre exemple de système de mesure apte à mettre en œuvre le procédé selon l'invention, dans lequel l'interféromètre de Mach-Zehnder de l'exemple précédent est remplacé par un interféromètre de Michelson. Ce système comprend :

- une source laser 1, avec une commande 11 de tension de modulation correspondant à une consigne de fréquence $f_0(t)$, munie d'une unité 111 de stockage de consignes numériques et d'un convertisseur 112 de ces consignes numériques en signaux analogiques $f_0(t)$,
- un coupleur 12 prélevant une partie de la lumière émise pour l'envoyer vers un interféromètre 2.
- un interféromètre 2 à deux bras de type Michelson avec un miroir 26 par exemple un miroir de Faraday à l'extrémité de chaque bras, une ligne à retard 21 sur l'un de ses bras, et un coupleur 23 permettant :

  ○ en entrée de séparer de préférence en deux parties égales la lumière issue du coupleur 12, et
  ○ en sortie de recombiner la lumière passant dans les deux bras,

- une photodiode 3 apte à convertir le signal d'intensité lumineuse issu de l'interféromètre 2, en un signal électrique analogique,
- un dispositif 4 de mesure des signaux fournis par la diode 3 qui comporte un convertisseur 41 de ces signaux analogiques en signaux numériques, et une unité de stockage 43 à des instants prédéterminés des signaux numériques issus du convertisseur 41,
- une unité de traitement 5 des signaux stockés, et de transmission d'une tension déterminée à la commande 11,
- un dispositif de synchronisation 6 entre l'unité de stockage 43 et la commande de tension 11, également reliée à l'unité de traitement.

Toutes ces configurations peuvent être fibrées.

Dans le cas du système de la figure 2b, grâce aux miroirs 26, le niveau du signal d'interférence est constant même lorsqu'on utilise des fibres optiques sans maintien de polarisation.

Dans ces deux exemples, une partie du champ du laser 1 est injectée dans l'interféromètre 2 dont l'un des deux bras est décalé d'un délai (ou retard) $\tau$ par la ligne à retard 21 ; l'autre partie est destinée à une application de télémétrie ou d'anémométrie par exemple, qui comme on peut le voir sur les figures 2a ou 2b n'intervient pas dans le procédé de modulation de la source (le signal de télémétrie ou d'anémométrie n'est pas utilisé pour la modulation de la source). Le signal d'interférence issu de l'interféromètre est ensuite converti en signal électrique à l'aide d'une photodiode 3, puis converti en signal numérique par le convertisseur 41 pour être stocké dans une mémoire tampon (buffer) 43. Un dispositif de synchronisation 6 est utilisé pour synchroniser l'acquisition du signal par la mémoire 43 avec la consigne de modulation de fréquence de la commande 11. L'acquisition de plusieurs périodes de modulation permet à une unité de traitement 5 de reconstruire la modulation de fréquence du laser 1 à l'aide d'un procédé original.

Le procédé selon l'invention fonctionne si les différentes périodes de modulation ont été acquises dans des conditions d'interférences distinctes. Ceci peut être obtenu « naturellement », par exemple du fait d'une dérive thermique de l'interféromètre ou d'une dérive de longueur d'onde du laser. Elle peut être aussi stimulée, par exemple si l'un des deux bras de l'interféromètre comporte un système de modulation de la phase (de l'ordre de $\pi/2$). Cette modulation de phase étant à basse fréquence (typiquement inférieure à 10 Hz), elle peut être obtenue simplement par un effet piézo-électrique ou un effet thermique.

La mesure de fréquence selon l'invention permet de s'affranchir du MAO rencontré dans les exemples de l'état de la technique. Elle repose sur un traitement du signal de battement obtenu en sortie de l'interféromètre 2. Dans cette architecture, ce signal de battement s'écrit :

$$x(t) = \cos\big(\varphi(t) - \varphi(t - \tau) + \psi(t, \tau)\big)$$

où la phase du laser à l'instant t s'écrit

$$\varphi(t) + \psi(t)$$

expression dans laquelle $\varphi(t)$ regroupe la variation de phase associée à la modulation de fréquence et $\psi(t)$ comprend l'ensemble des termes associés à la fréquence moyenne et aux fluctuations parasites de phase (issues par exemple du bruit de phase). $\psi(t, \tau)$ est une phase qui dépend de la variation de chemin optique entre les bras de l'interféromètre 2 mais qui fluctue peu à l'échelle de la période de la modulation de fréquence. En pratique $\tau$ évolue de manière significative par rapport à $\lambda/c$ (on a typiquement $\Delta\tau > 10\%$ $\lambda/c$, où c désigne la vitesse de la lumière et $\lambda$ la longueur d'onde de la source) mais évolue peu en relatif (typiquement inférieur à 1% soit $(\Delta t/\tau) < 0.01$, $\Delta\tau$ étant l'évolution de $\tau$ sur plusieurs périodes T).

La fréquence du laser f(t) étant proportionnelle à la dérivée de la phase, on a :

$$x(t) = \cos\big(\varphi(t) - \varphi(t - \tau) + \psi(t, \tau)\big)$$
$$x(t) = \cos\left(2\pi \int_{t-\tau}^{t} f(u)du + \psi(t, \tau)\right)$$
$$\approx \cos\big(2\pi\tau f(t) + \psi(t, \tau)\big)$$

Le traitement développé vise à isoler la contribution de la fréquence f(t) par rapport aux fluctuations de phase $\psi(t,\tau)$, c'est-à-dire à s'affranchir de $\psi(t,\tau)$ à une constante près. Ce traitement suppose que le signal de modulation est périodique (de période T) et utilise deux échelles de temps pour mesurer la fréquence f(t) :

- une échelle de temps courte pendant laquelle f(t) varie et $\psi(t,\tau)$ est constant, soit typiquement quelques $\mu s$,
- une échelle de temps longue au cours de laquelle $\psi(t,\tau)$ a évolué, soit typiquement quelques secondes à quelques minutes.

En pratique, il est nécessaire de mesurer le signal $x_i(t)$ sur m périodes distinctes avec une échelle de temps longue couvrant plusieurs périodes de modulation, pour obtenir :

$$x_i(t) = x(t - k_i T) \text{ avec } 1 \le i \le m, \, k_i \in \mathbb{N}, 0 \le t < T.$$

Les mesures de $x_i(t)$ à ces instants $k_i T$ sont dites homologues. La reconstruction de la fréquence émise par le laser ne peut être réalisée qu'à l'issue de plusieurs périodes de mesures espacées par une échelle de temps plus longue.

On suppose que les effets thermiques et de vieillissement sont suffisamment réduits, ou plus généralement que les conditions d'interférence sont suffisamment stables pour que le déphasage $\psi(t,\tau)$ entre les bras de l'interféromètre reste constant sur une période T de modulation, soit :

$$\psi\big(t - k_i T, \tau\big) \approx cste = \psi_i \text{ pour } 0 < t < T$$

On peut alors indexer les vecteurs temporels mesurés sous la forme :

$$x_i(t) = \cos(2\pi\tau f(t - k_i T) + \psi_i) = \cos(2\pi\tau f(t) + \psi_i)$$

et considérer le vecteur dépendant du temps : x(t) = (x₁ (t), ..., xₘ(t))ᵀ, le symbole T en exposant signifiant la transposée.

Dans le cas à deux dimensions, le vecteur

$$\mathrm{x(t)} \ = \ \left(x_1(t), x_2(t)\right)^T \ = \ \left(\cos\!\left(2\pi\tau\, f(t) + \psi_1\right), \cos\!\left(2\pi\tau\, f(t) + \psi_2\right)\right)^T$$

décrit une ellipse si $\psi_1 \neq \psi_2$ comme illustré sur la figure 3a.

Le point P a pour coordonnées (cos(α(t)+ ψ₁), cos(α(t)+ ψ₂)). La connaissance de α ne peut être réalisée qu'à une constante près. L'acquisition de plusieurs points P(a) décrit une ellipse caractérisée par

$$\psi_2 - \psi_1$$

mais il n'y a pas de construction géométrique immédiate permettant de déduire l'ellipse de $\psi_1$ et $\psi_2$. A deux dimensions, pour déterminer α à partir de l'ensemble des points de l'ellipse, une technique consiste à transformer l'ellipse en cercle de manière à retrouver une définition naturelle (ie. un angle) pour a. Pour cela, on peut réaliser les opérations suivantes :

- Déterminer l'excentricité de l'ellipse. Pour cela, compte tenu du fait que les axes de l'ellipse sont toujours à +/- 45 degrés, il faut déterminer le maximum des projections de la trajectoire du point x (l'ellipse) sur les axes (1,1) et (1, -1). On note $M_1$ le maximum selon (1,1) et $M_{-1}$ le maximum selon (1, -1,).
- Réaliser une dilatation de l'axe (1,1) de paramètre $1/M_1$ et de l'axe (1,-1) avec un paramètre $1/M_{-1}$ (en réalisant par exemple une rotation de - 45 deg, suivie d'une dilatation des axes des abscisses avec un paramètre $1/M_1$ et de l'axe des ordonnées avec un paramètre $1/M_{-1}$ suivie d'une rotation de +45 deg.).

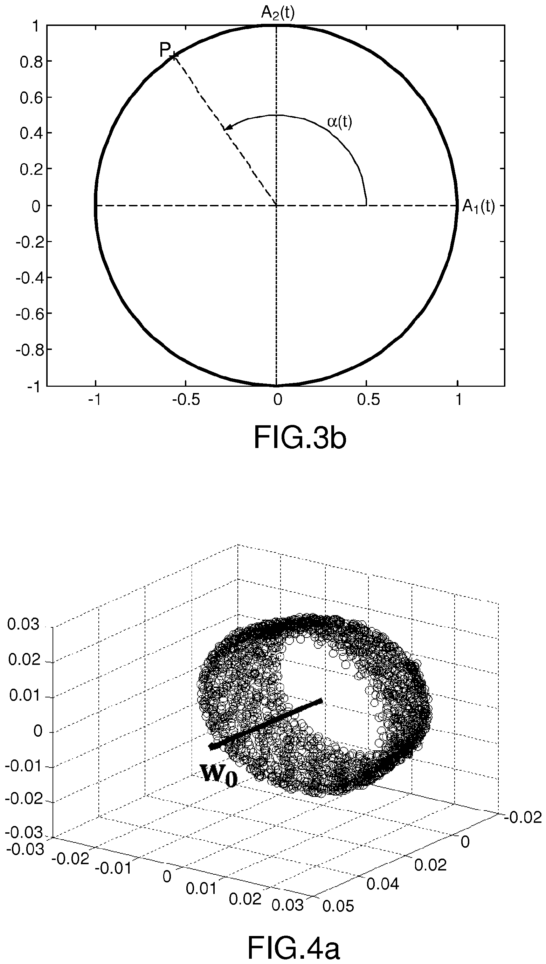

Avec ces opérations qui transforment les axes x1 et x2 en A1 et A2, la figure 3a se transforme en la figure 3b : α est alors, à une constante près, directement la phase du point le long du cercle.

De la même manière, pour une dimension m, x(t) doit décrire une ellipse dans un plan bien choisi de $\mathbb{R}^m$. Sur cette ellipse, la phase du point x fournit directement : $\alpha(t) = 2\pi f(t)$.

Pour connaître l'axe de l'ellipse, la matrice de covariance :
Γ= <x(t)x(t)ᵀ> est calculée puis diagonalisée pour définir les vecteurs propres $v_i$ et les valeurs propres $\lambda_i$:

$$\Gamma\, v_i = \lambda_i\, v_i$$

$\lambda_1 \geq \lambda_2 \geq ... \geq \lambda_m \geq 0$ : valeurs propres

$(v_1, v_2, ..., v_m)$ : base orthonormale de $\mathbb{R}^m$ (vecteurs propres).

En pratique, seules les 3 plus grandes des valeurs propres sont non négligeables. On calcule donc la projection de x dans le sous-espace formé par (v1, v2, v3), ce qui permet de diminuer la dimensionnalité du problème. Un exemple de résultat expérimental de la trajectoire {x(t), 0 ≤ t ≤ T} du vecteur x(t) dans ce sous-espace est présenté sur la figure 3b : cette trajectoire est obtenue pour m=400 périodes de 200 μs mesurées sur environ 10s avec un échantillonnage à 125 MHz soit environ 25000 points par période (à partir de 5000 points par période, on obtient déjà un bon résultat). On a typiquement la période T comprise entre 10 à 800 μs et le retard τ évolue typiquement sur une durée comprise entre 1 s et 300 s. Les points s'organisent sur un cylindre elliptique d'axe $w_0$. Pour connaître l'axe de l'ellipse $w_0$, on cherche à minimiser un critère C(w) tel que la variance de la norme relativement au carré de la norme (on choisit le plan de projection pour obtenir la forme la plus circulaire possible) :

$$C(\mathbf{w}) = \frac{\left\langle \|\,p_{\mathbf{w}}(\mathbf{x})\,\|^4 \right\rangle}{\left\langle \|\,p_{\mathbf{w}}(\mathbf{x})\,\|^2 \right\rangle^2} - 1$$

où $p_w(x)$ désigne la projection de x selon l'axe w.

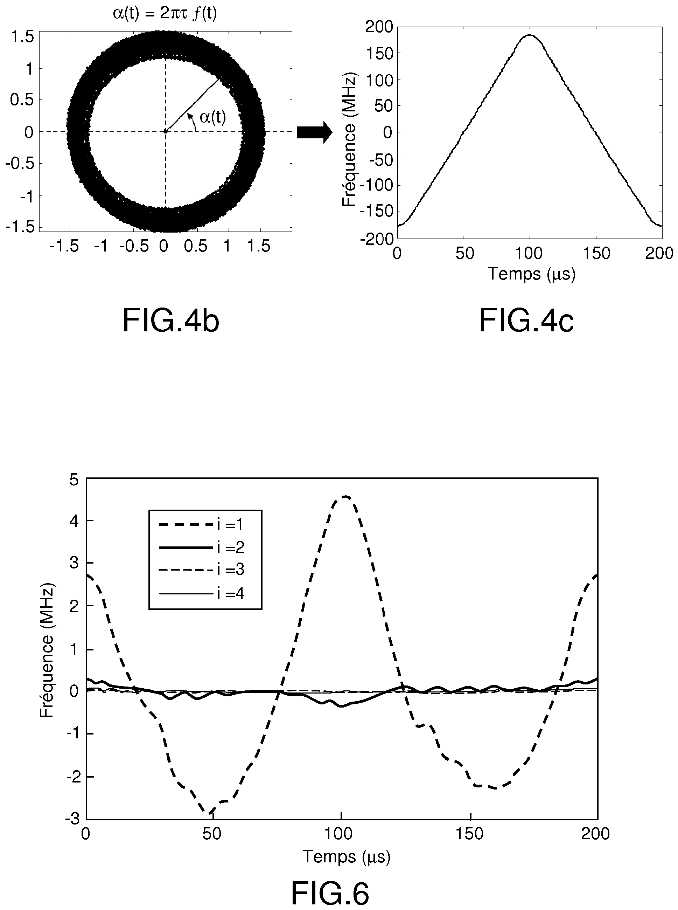

En projetant les points x selon $w_0$, on obtient une forme légèrement elliptique qui, après re-normalisation, permet de déduire comme on peut le voir figure 4a

$$\alpha(t) \cong 2\pi\tau\, f(t)$$

et donc la fréquence au cours du temps comme illustré sur la figure 4b.

Différentes fréquences f(t) ont ainsi pu être évaluées simultanément, à l'aide de cette technique, en implémentant par exemple une fréquence f(t) complexe comprenant sur une même période T une partie

- Constante
- Sinusoïdale
- Parabolique
- Triangulaire.

On a décrit un mode de traitement des signaux $x_i(t)$ basé sur leur organisation sous forme de vecteurs. D'autres traitements peuvent être envisagés comme par exemple, une régression linéaire itérative, un recuit simulé, des algorithmes récursifs, génétiques ou de type Monte Carlo prenant en compte l'ensemble des mesures.

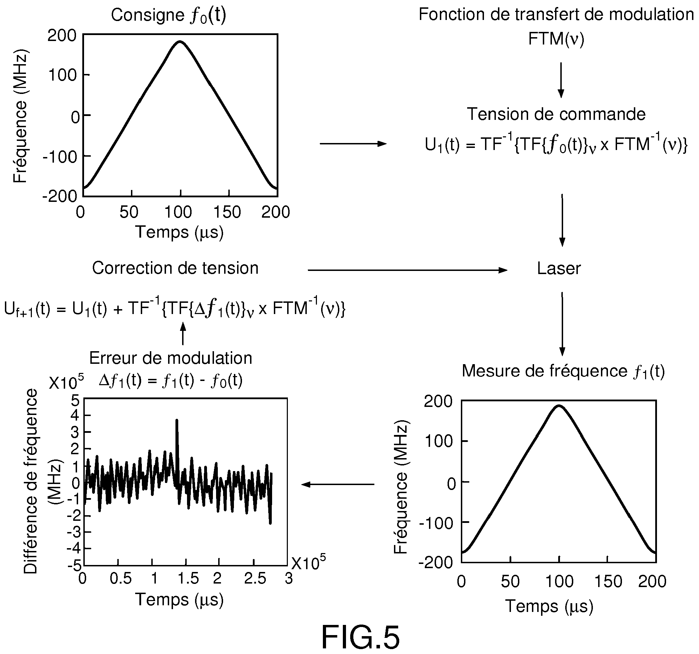

Ce procédé peut notamment être utilisé pour calibrer la fréquence de la source laser d'un Lidar selon une consigne $f_0(t)$, sans utiliser de MAO. Une telle procédure permet de s'affranchir des dérives possibles de la fonction de transfert du laser (liées à la température, au vieillissement de la diode...). Les principales étapes de calibrage décrites en relation avec la figure 5 se déroulent de la manière suivante.

Une première étape consiste à définir une transformation linéaire entre la tension de commande et la fréquence du laser. Cette transformation linéaire peut avantageusement être obtenue par la mesure de la fonction de transfert de la modulation de fréquence. Ceci est alors réalisé en envoyant un bruit blanc connu par exemple sur une bande de fréquence comprise entre 0 et 150 kHz, comme tension de commande de la modulation de la forme

$$U(t) = U_0 \sum_k \cos\big(2\pi kt/T + \phi_k\big)$$

où les $\phi k$ sont des phases aléatoires indépendantes, et en mesurant la fréquence émise, par le procédé précédemment décrit. La fonction de transfert de modulation s'obtient par la relation :

$$\mathrm{FTM}(\nu) = \frac{\mathrm{TF}\{f(t)\}_\nu}{\mathrm{TF}\{U(t)\}_\nu}$$

Le processus de calibrage est ensuite itératif pour prendre en compte la non-linéarité (constatée expérimentalement) de cette fonction de transfert :

- à partir de la consigne en fréquence, on calcule une première tension à appliquer sur la diode laser, en utilisant une transformation linéaire de cette consigne, par exemple à l'aide de la fonction de transfert de modulation comme :

$$U_1(t) = TF^{-1}\{TF\{f_0(t)\}_\nu \times FTM^{-1}(\nu)\},$$

- la fréquence émise $f_1(t)$ est mesurée par le procédé précédemment décrit ;
- l'erreur de fréquence par rapport à la consigne $\Delta f_i(t) = f_i(t) - f_0(t)$ est déduite de la mesure précédente ;
- cette erreur permet de définir une correction de la tension de commande définie à partir de $\Delta f_i(t)$ et de la fonction définie précédemment (par exemple la FTM) :

$$U_{i+1}(t) = U_i(t) - TF^{-1}\{TF\{\Delta f_i(t)\}_\nu \times FTM^{-1}(\nu)\}$$

- le système boucle sur les 3 points précédents pour affiner la tension de commande requise et donc la fréquence émise.

Deux itérations permettent généralement d'obtenir un résultat satisfaisant et, typiquement, 3 à 4 itérations sont suffisantes pour atteindre le minimum d'erreur accessible (soit environ 1 minute) comme illustré figure 6.

Ces procédés de mesure et de calibrage permettent de s'affranchir du MAO rencontré dans les exemples de l'état de la technique. Mais son utilisation n'est pas exclue ; on peut en effet éventuellement ajouter un MAO sur l'un des bras de l'interféromètre pour éviter un bruit basse fréquence.

Le traitement du signal de battement peut s'implémenter à partir d'éléments matériel et/ou logiciel. Il peut être disponible en tant que produit programme d'ordinateur enregistré sur un support lisible par ordinateur, ce programme d'ordinateur comprenant des instructions de code permettant d'effectuer les étapes du procédé de reconstruction. Le support peut être électronique, magnétique, optique, électromagnétique ou être un support de diffusion de type infrarouge. De tels supports sont par exemple, des mémoires à semi-conducteur (Random Access Memory RAM, Read-Only Memory ROM), des bandes, des disquettes ou disques magnétiques ou optiques (Compact Disk - Read Only Memory (CD-ROM), Compact Disk - Read/Write (CD-R/W) and DVD).

Bien que l'invention ait été décrite en liaison avec des modes de réalisation particuliers, il est bien évident qu'elle n'y est nullement limitée et qu'elle comprend tous les équivalents techniques des moyens décrits ainsi que leurs combinaisons si celles-ci entrent dans le cadre de l'invention.

**Revendications**

1. Procédé de mesure de la modulation de fréquence f(t) d'une source laser (1) qui comprend les étapes suivantes :

   - modulation de la source laser selon une période T, par une commande de modulation (11),
   - au cours d'une même période T, réalisation de plusieurs mesures d'une intensité lumineuse de battement entre deux bras d'un interféromètre (2) situé en aval de la source laser et apte à introduire un retard $\tau$ entre les deux bras, ces mesures étant synchronisées avec la commande de la modulation,
   - calcul de la fréquence f(t) à partir des mesures,
   **caractérisé en ce que**
   - pendant chaque période T, f(t) varie,
   - sur plusieurs périodes T, le retard $\tau$ évolue temporellement, avec $\Delta\tau > 10\%$ $\lambda/c$, et $\Delta\tau/\tau < 0.01$ où c désigne la vitesse de la lumière et $\lambda$ la longueur d'onde de la source,
   - les mesures sont effectuées à l'instant $t_i$ au cours d'une même période et réitérées à $t_i + kT$, avec $k \geq 1$, le retard $\tau$ ayant évolué d'une itération à l'autre,
   - et **en ce qu'**il comprend une étape de

      - calcul d'une matrice de covariance à partir de vecteurs temporels x(t), les composantes de chaque vecteur x(t) étant lesdites mesures réalisées au cours d'une même période T, les vecteurs temporels étant séparés de kT,
      - calcul de vecteurs propres et de valeurs propres de la matrice de covariance,
      - projection des vecteurs temporels x(t) sur les vecteurs propres associés aux plus grandes valeurs propres non négligeables, de manière à former une forme elliptique ayant un axe principal,
      - la modulation de fréquence étant obtenue par l'angle formé à partir des projections des vecteurs x(t) autour de l'axe principal.

2. Procédé de mesure de la modulation de fréquence f(t) d'une source laser selon la revendication précédente, **caractérisé en ce que** la variation temporelle du retard $\tau$ est stimulée au moyen d'un dispositif piézo-électrique.

3. Procédé de mesure de la modulation de fréquence f(t) d'une source laser selon l'une des revendications précédentes, **caractérisé en ce que** l'angle est proportionnel à f(t).

4. Procédé de mesure de la modulation de fréquence f(t) d'une source laser selon l'une des revendications précédentes, **caractérisé en ce que** la période T est de l'ordre de quelques $\mu$s, et le retard $\tau$ évolue sur une durée variant d'une seconde à quelques minutes.

5. Procédé de calibrage de la fréquence de la source laser (1) d'un lidar selon une consigne $f_0(t)$, qui comprend les étapes suivantes :

   - modulation de la fréquence de la source laser (1) au moyen d'une tension de commande périodique U(t) prédéterminée,
   - définition d'une transformation linéaire entre f(t) et U(t),
   - calcul d'une première tension de commande $U_1(t)$ à partir de $f_0(t)$ et de ladite transformation linéaire,
   - i=1 et itération des étapes suivantes :

∘ mesure de la fréquence $f_i(t)$ de la source laser selon l'une des revendications précédentes,

∘ calcul de l'erreur $\Delta f_i(t)=f_i(t) - f_0(t)$ et d'une tension de commande de correction à partir de $\Delta f_i(t)$ et de ladite transformation linéaire,

∘ définition d'une nouvelle tension de commande $U_{i+1}(t)$ à partir de la tension de commande précédente $U_i(t)$ et de la tension de commande de correction,

∘ i=i+1.

6. Procédé de calibrage selon la revendication précédente, **caractérisé en ce que** la transformation linéaire entre f(t) et U(t) est obtenue par la mesure de la fonction de transfert de la modulation de fréquence désignée FTM.

7. Procédé de calibrage selon l'une des revendications 5 ou 6, **caractérisé en ce que** le nombre d'itérations est inférieur à 10.

8. Un produit programme d'ordinateur, ledit programme d'ordinateur comprenant des instructions de code permettant d'effectuer les étapes du procédé selon l'une quelconque des revendications 1 à 7 en utilisant le système de la revendication 9, lorsque ledit programme est exécuté sur un ordinateur.

9. Système de mesure de la modulation de fréquence f(t) d'une source laser qui comprend :

   - la source laser (1) associée à une commande (11) de modulation,
   - un interféromètre à deux bras (2) avec une ligne à retard (21) sur l'un des bras,
   - un dispositif (4) de mesure de signaux de battement issus de l'interféromètre,
   - une unité (5) de traitement des signaux mesurés,
   - un dispositif de synchronisation (6) relié à la commande de modulation (11) et à l'unité de traitement,

   **caractérisé en ce que** l'unité de traitement est adaptée pour mettre en œuvre le procédé selon l'une des revendications 1 à 7.

10. Système de mesure de la modulation de fréquence selon la revendication précédente, **caractérisé en ce que** l'interféromètre (2) est de type Mach-Zehnder ou Michelson.

11. Système de mesure de la modulation de fréquence selon l'une des revendications 9 ou 10, **caractérisé en ce que** l'interféromètre (2) ne comporte pas de modulateur acousto-optique.

**Patentansprüche**

1. Verfahren zum Messen der Frequenzmodulation f(t) einer Laserquelle (1), das die folgenden Schritte umfasst:

   - Modulieren der Laserquelle über eine Periode T durch eine Modulationssteuerung (11),
   - Durchführen, im Laufe einer gleichen Periode T, mehrerer Messungen einer Schwebungslichtstärke zwischen zwei Armen eines Interferometers (2), das sich stromabwärts der Laserquelle befindet und eine Verzögerung $\tau$ zwischen den beiden Armen einführen kann, wobei diese Messungen mit der Modulationssteuerung synchronisiert werden,
   - Berechnen der Frequenz f(t) aus den Messungen,
   **dadurch gekennzeichnet, dass**
   - f(t) während jeder Periode T variiert,
   - die Verzögerung $\tau$ über mehrere Perioden T zeitlich variiert, mit $\Delta\tau > 10\%$ $\lambda/c$ und $\Delta\tau/\tau < 0{,}01$, wobei c die Lichtgeschwindigkeit und $\lambda$ die Wellenlänge der Quelle bezeichnet,
   - die Messungen zum Zeitpunkt $t_i$ im Laufe einer selben Periode durchgeführt und zum Zeitpunkt $t_i+kT$ wiederholt werden, mit $k\geq 1$, wobei die Verzögerung $\tau$ von einer Iteration zur nächsten variiert,
   - und dadurch, dass es den folgenden Schritt umfasst:

     - Berechnen einer Kovarianzmatrix auf der Basis von Zeitvektoren x(t), wobei die Komponenten jedes Vektors x(t) die Messungen sind, die im Laufe einer gleichen Periode T durchgeführt wurden, wobei die Zeitvektoren durch kT getrennt sind,
     - Berechnen von Eigenvektoren und Eigenwerten der Kovarianzmatrix,
     - Projizieren der Zeitvektoren x(t) auf die Eigenvektoren, die mit den größten nicht vernachlässigbaren Eigenwerten assoziiert sind, so dass eine elliptische Form mit einer Hauptachse entsteht,
- wobei die Frequenzmodulation durch den Winkel erhalten wird, der auf der Basis der Projektionen der Vektoren x(t) um die Hauptachse gebildet wird.

2. Verfahren zum Messen der Frequenzmodulation f(t) einer Laserquelle nach dem vorherigen Anspruch, **dadurch gekennzeichnet, dass** die zeitliche Variation der Verzögerung $\tau$ mit Hilfe einer piezoelektrischen Vorrichtung stimuliert wird.

3. Verfahren zum Messen der Frequenzmodulation f(t) einer Laserquelle nach einem der vorherigen Ansprüche, **dadurch gekennzeichnet, dass** der Winkel proportional zu f(t) ist.

4. Verfahren zum Messen der Frequenzmodulation f(t) einer Laserquelle nach einem der vorherigen Ansprüche, **dadurch gekennzeichnet, dass** die Periode T in der Größenordnung von einigen $\mu$s liegt und die Verzögerung $\tau$ über einen Zeitraum variiert, der von einer Sekunde bis zu einigen Minuten variiert.

5. Verfahren zum Kalibrieren der Frequenz der Laserquelle (1) eines Lidars nach einem Sollwert $f_0(t)$, das die folgenden Schritte umfasst:

   - Modulieren der Frequenz der Laserquelle (1) mittels einer vorbestimmten periodischen Steuerspannung U(t),
   - Definieren einer linearen Transformation zwischen f(t) und U(t),
   - Berechnen einer ersten Steuerspannung $U_1(t)$ aus $f_0(t)$ und der linearen Transformation,
   - i=1 und Wiederholen der folgenden Schritte:

     ◦ Messen der Frequenz $f_i(t)$ der Laserquelle nach einem der vorherigen Ansprüche,
     ◦ Berechnen des Fehlers $\Delta f_i(t)=f_i(t)-f_0(t)$ und einer Korrektursteuerspannung aus $\Delta f_i(t)$ und der linearen Transformation,
     ◦ Definieren einer neuen Steuerspannung $U_{i+1}(t)$ auf der Basis der vorherigen Steuerspannung $U_i(t)$ und der Korrektursteuerspannung,
     ◦ i=i+1.

6. Kalibrierverfahren nach dem vorherigen Anspruch, **dadurch gekennzeichnet, dass** die lineare Transformation zwischen f(t) und U(t) durch Messen der Übertragungsfunktion der Frequenzmodulation, bezeichnet als FTM, erhalten wird.

7. Kalibrierverfahren nach einem der Ansprüche 5 oder 6, **dadurch gekennzeichnet, dass** die Anzahl von Wiederholungen weniger als 10 beträgt.

8. Computerprogrammprodukt, wobei das Computerprogramm Codebefehle zum Zulassen der Durchführung der Schritte des Verfahrens nach einem der Ansprüche 1 bis 7 unter Verwendung des Systems nach Anspruch 9 umfasst, wenn das Programm auf einem Computer ausgeführt wird.

9. System zum Messen der Frequenzmodulation f(t) einer Laserquelle, das Folgendes umfasst:

   - die Laserquelle (1), welche mit einer Modulationssteuerung (11) assoziiert ist,
   - ein zweiarmiges Interferometer (2) mit einer Verzögerungsleitung (21) auf einem der Arme,
   - eine Vorrichtung (4) zur Messung von Schwebungssignalen von dem Interferometer,
   - eine Einheit (5) zur Verarbeitung der gemessenen Signale,
   - eine Synchronisationsvorrichtung (6), die mit der Modulationssteuerung (11) und mit der Verarbeitungseinheit verbunden ist,

   **dadurch gekennzeichnet, dass** die Verarbeitungseinheit zum Durchführen des Verfahrens nach einem der Ansprüche 1 bis 7 geeignet ist.

10. System zur Messung der Frequenzmodulation nach dem vorherigen Anspruch, **dadurch gekennzeichnet, dass** das Interferometer (2) vom Mach-Zehnder- oder Michelson-Typ ist.

11. System zur Messung der Frequenzmodulation nach einem der Ansprüche 9 oder 10, **dadurch gekennzeichnet, dass** das Interferometer (2) keinen akusto-optischen Modulator umfasst.

**Claims**

1. A method for measuring the frequency modulation f(t) of a laser source (1) that comprises the following steps:

   - modulating the laser source over a period T, with a modulation controller (11);
   - in a given period T, carrying out several measurements of a beat light intensity between two arms of an interferometer (2) located downstream of the laser source and able to introduce a delay $\tau$ between the two arms, these measurements being synchronized with the control of the modulation;
   - calculating the frequency f(t) from the measurements;
   **characterized in that**
   - during each period T, f(t) varies,
   - the delay $\tau$ varies as a function of time over several periods T, with $\Delta\tau > 10\%$ $\lambda/c$, and $\Delta\tau/\tau < 0{,}01$, where c is the speed of light and $\lambda$ the wavelength of the source;
   - the measurements are carried out at the time $t_i$ in a given period and reiterated at $t_i+kT$, with $k\geq1$, the delay $\tau$ having varied from one iteration to the next,
   - and **in that** it comprises a step of
   - calculating a covariance matrix from temporal vectors x(t), the components of each vector x(t) being said measurements carried out in a same period T, the temporal vectors being separated by kT,
   - calculating eigenvectors and eigenvalues of the covariance matrix,
   - projecting the temporal vectors x(t) onto the eigenvectors associated with the highest non-negligible eigenvalues, so as to form an elliptical shape having a main axis,
   - the frequency modulation being obtained by the angle formed from projections of the vectors x(t) around the main axis.

2. The method for measuring the frequency modulation f(t) of a laser source according to the preceding claim, **characterized in that** the variation as a function of time of the delay $\tau$ is stimulated by means of a piezoelectric device.

3. The method for measuring the frequency modulation f(t) of a laser source according to one of the preceding claims, **characterized in that** the angle is proportional to f(t).

4. The method for measuring the frequency modulation f(t) of a laser source according to one of the preceding claims, **characterized in that** the period T is about a few $\mu$s, and the delay $\tau$ varies over a duration varying from one second to a few minutes.

5. A method for calibrating the frequency of the laser source (1) of a lidar to a setpoint $f_0(t)$, which comprises the following steps:

   - modulating the frequency of the laser source (1) by means of a preset periodic control voltage U(t);
   - defining a linear transformation between f(t) and U(t);
   - calculating a first control voltage $U_1(t)$ from $f_0(t)$ and said linear transformation;
   - i=1 and iterating the following steps:

     ○ measuring the frequency $f_i(t)$ of the laser source according to one of the preceding claims;
     ○ calculating the error $\Delta f_i(t) = f_i(t) - f_0(t)$ and a correcting control voltage from $\Delta f_i(t)$ and said linear transformation;
     ○ defining a new control voltage $U_{i+1}(t)$ from the preceding control voltage $U_i(t)$ and the correcting control voltage;
     ○ i=i+1.

6. The calibrating method according to the preceding claim, **characterized in that** the linear transformation between f(t) and U(t) is obtained by measuring the transfer function of the frequency modulation, which is designated the FTM.

7. The calibrating method according to any one of claims 5 or 6, **characterized in that** the number of iterations is lower than 10.

8. A computer-program product, said computer program comprising code instructions allowing the steps of the method according to any one of claims 1 to 7 to be carried out using the system of claim 9, when said program is executed on a computer.

9. A system for measuring the frequency modulation f(t) of a laser source that comprises:

   - the laser source (1) associated with a modulation controller (11);
   - a two-arm interferometer (2) with a delay line (21) on one of the arms;
   - a device (4) for measuring beat signals generated by the interferometer;
   - a unit (5) for processing the measured signals;
   - a synchronizing device (6) that is connected to the modulation controller (11) and to the processing unit;

   **characterized in that** the processing unit is suitable for implementing the method according to one of claims 1 to 7.

10. The system for measuring frequency modulation according to the preceding claim, **characterized in that** the interferometer (2) is of Mach-Zehnder or Michelson type.

11. The system for measuring frequency modulation according to any one of claims 9 or 10, **characterized in that** the interferometer (2) does not include any acousto-optical modulator.

FIG.1a

FIG.1b

FIG.1c

Modulation de phase ou perturbation extérieure

FIG.2a

FIG.2b

FIG.3a

FIG.3b

FIG.4a

## FIG.4b

## FIG.4c

## FIG.6

Consigne $f_0(t)$

Fonction de transfert de modulation
FTM($\nu$)

Tension de commande

$$U_1(t) = TF^{-1}\{TF\{f_0(t)\}_\nu \times FTM^{-1}(\nu)\}$$

Correction de tension

Laser

$$U_{f+1}(t) = U_1(t) + TF^{-1}\{TF\{\Delta f_1(t)\}_\nu \times FTM^{-1}(\nu)\}$$

Erreur de modulation
$\Delta f_1(t) = f_1(t) - f_0(t)$

Mesure de fréquence $f_1(t)$

FIG.5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5808743 A